# EUROPEAN PATENT SPECIFICATION

(11) **EP 0 604 200 B1**
(45) Date of publication and mention of the grant of the patent: **20.05.1998**
(21) Application number: 93310397.0
(22) Date of filing: 21.12.1993
(51) Int. Cl.: H01L 27/06, H01L 27/092

(54) **Complementary field effect transistor**
Komplementärer Feldeffekt-Transistor
Transistor complémentaire à effet de champ

(30) Priority: 23.12.1992 GB 9226847
(43) Date of publication of application: 29.06.1994
(73) Proprietor: HITACHI EUROPE LIMITED, Maidenhead, Berkshire, SL6 8YA (GB)
(72) Inventor: Blaikie, Richard, c/o Hitachi Europe Ltd., Cambridge CB3 0HE (GB)
(74) Representative: Read, Matthew Charles

(56) References cited:
- EP-A- 0 464 834
- EP-A- 0 519 830
- EP-A- 0 521 700
- PATENT ABSTRACTS OF JAPAN vol. 11, no. 288 (E-542) (2735) 17 September 1987 & JP-A-62 089 365 (FUJITSU LTD)
- PATENT ABSTRACTS OF JAPAN vol. 10, no. 217 (E-423) (2273) 29 July 1986 & JP-A-61 054 670 (FUJITSU LTD) 18 March 1986
- PATENT ABSTRACTS OF JAPAN vol. 6, no. 247 (E-146) 7 December 1982 & JP-A-57 147 272 (MITSUBISHI DENKI K.K.) 11 September 1982
- PATENT ABSTRACTS OF JAPAN vol. 11, no. 280 (E-539) (2727) 10 September 1987 & JP-A-62 081 063 (NIPPON TELEGR & TELEPH CORP) 14 April 1987

## Description

This invention relates to a complementary conductive device having particular application to complementary logic devices.

Complementary logic circuitry is usually fabricated using Metal-Oxide Semiconductor-Field-Effect-Transistor (MOSFET) structures, with silicon as the semiconductor. Such circuitry has been used in a wide variety of applications, for example in electronic calculators and in the central processing units of many microcomputers. As is well known in the art, MOSFET technology makes use of complementary pairs of transistors to define logic gates. This gives rise to reliable operation but has a disadvantage that two transistors with associated connections are required, spread out in a lateral configuration which takes up a considerable amount of space in the semiconductor device. The use of "in-plane gates" in layered structures has also been widely reported, for example by Wieck & Ploog - Surface Science 229, 252 - 259, 1990. Reference is also directed to DE-P3914007.5.

Complementary vertical CMOS transistors are disclosed in US-A-5 010 386 and EP-A-0 521 700 that include first and second layers of different conductivity type overlying one another to provide first and second complementary conductive channels; and a gate means for applying a common gate field to both of said channels concurrently, so as to produce complementary changes in the conductivity thereof.

However, this prior arrangement suffers from the disadvantage that it is difficult to make connections to the complementary channels due to the vertical structure of the device.

A complementary conductive device according to the present invention is defined in claim 1.

A device according to the invention can be used to provide circuits that perform different logical functions for example Invert, NAND and NOR logic operations.

In order that the invention may be more fully understood embodiments thereof will now be described by way of example with reference to the accompanying drawings in which:
Figure 1 is a cross sectional view of a starting material for forming devices in accordance with the invention, showing overlying complementary P and N type layers;
Figure 2 illustrates in section the formation of selective contacts with the P and N type layers shown in Figure 1;
Figure 3a is a plan view of the device in accordance with the invention, including an in-plane gate for controlling current flow in overlying P and N type channels formed from the layers shown in Figure 1;
Figure 3b is a sectional view taken along the line A-A' shown in Figure 3a;
Figure 4 is a graph illustrating the voltage-current characteristics of the P and N type layers shown in Figure 1;
Figure 5a, b, and 2 are respectively circuit diagrams for Invert, NAND and NOR logic functions using P and N type transistors as shown in Figure 3, as the basic circuit elements;
Figure 6a is a plan view of an inverter corresponding to the circuit of Figure 5a;
Figure 6b is a sectional view taken along the line A-A' of Figure 6a;
Figure 6c is a sectional view taken along the line B-B' of Figure 6a;
Figure 6d is a sectional view taken along the line C-C' of Figure 6a;
Figure 7 is a plan view of a NAND circuit;
Figure 8 is a plan view of a NOR circuit; and
Figure 9 illustrates in section the formation of selective contacts with N and P type layers in a structure with three conductive layers.

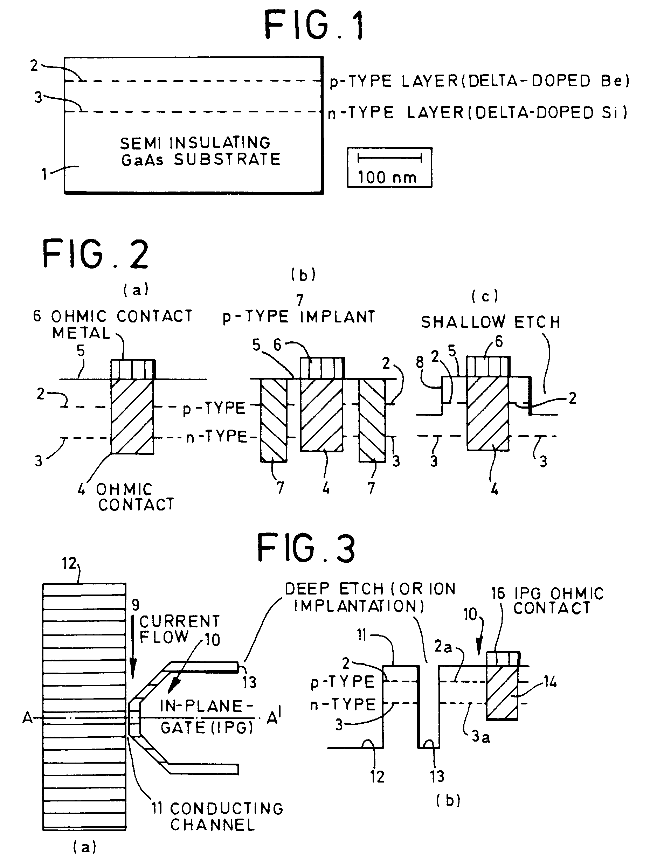

Referring firstly to Figure 1, the starting material for forming a device in accordance with the invention is shown schematically in sectional view. A scale is shown to the righthand side of the Figure. The devices described herein will be referred to as Complementary In-Plane-Gate Logic (CIPGL) circuits. The CIPGL circuits having overlying P and N type layers which are used as complementary conductive channels. Thus, the starting material for the circuits shown in Figure 1 consists of a semiconductor substrate 1 which contains a first P type layer 2 which overlies a second N type layer 3. Thus, conduction by means of electrons can occur in the layer 2 whereas conduction in layer 3 is by holes.

The P and N type layers 2, 3 can be formed in the substrate 1 in a number of different ways and a specific example will be described hereinafter. Those skilled in the art will be able to devise alternatives.

In the embodiments described hereinafter, the substrate 1 consists of semi-insulating GaAs, the P type dopant for layer 2 is beryllium (Be), the N type dopant is silicon (Si) and the layers are grown by Molecular Beam Epitaxy (MBE) or Metallo-Organic Chemical Vapour Deposition (MOCVD). In both of these growth processes, the thickness of the dopant layers can be controlled to within a single atomic layer, and when the dopant is introduced into only one atomic layer the material is said to be delta-doped.

There are two principal requirements for the CIPGL circuit. Firstly, ohmic contacts need to be formed to the P-type and N-type layers 2, 3 so that current may be fed into each layer independently. Secondly, at least one In-Plane-Gate (IPG) is provided which simultaneously controls the flow of current through both the P-type and N-type layers 2, 3 in a complementary fashion; i.e. for one gate voltage, the current flow will be stopped in the N-type layer but not in the P-type layer, and at a different gate voltage, the reverse situation will occur.

A method of forming separate ohmic contacts to the P-type and N-type layers 2, 3 will now be described. In both cases, the first stage involves the formation of an ohmic contact to both layers simultaneously as shown schematically in Figure 3a. In the aforementioned delta-doped GaAs system, this is achieved by alloying an indium containing compound e.g. silver/indium, into the substrate 1 from above at a high temperature ( = 600°C) so as to form a contact land 4. Other compounds could be used and the main requirement is that an ohmic contact is formed to both the conducting layers 2, 3 within the substrate. The ohmic contact land 4 extends to the surface 5 of the substrate and is provided with an overlying metallisation layer 6 to provide an external connection.

Figures 2b and c show how the contact arrangement of Figure 2a can be converted to contact solely the P-type layer 2 or the N-type layer 3. This is achieved by selectively electrically isolating a region around the ohmic contact 4 where contact is not desired.

Thus, referring to Figure 2b, in order to make contact solely with the P-type layer 2, the isolation can be achieved by implanting or diffusing P-type dopants 7 (e.g. Be for the GaAs material) to a depth which is greater than the depth of the N-type layer 3. This isolates the ohmic contact land 4 from the N-type layer 3 but conduction can occur from the P-type layer 2 through the regions 7 to the ohmic contact 4.

Referring to Figure 2c, for the N-type contact the isolation is achieved by physically removing the P-type layer 2, for example by a chemical etch, from around the contact. Such etching produces a step 8 as shown in Figure 2c so that the channel formed by P-type layer 2 is physically disconnected from the ohmic contact land 4.

As previously explained, the second requirement for the CIPGL circuit is the common gate structure which produces a complementary control action for the P and N-type layers 2, 3. Such a complementary in-plane-gate is shown in Figure 3 cooperating with complementary channels formed by the layers 2, 3 to form a transistor referred to herein as an IPG transistor.

Referring to the plan view shown in Figure 3a, current flows through the transistor in overlying complementary P and N-type channels formed by the P and N-type layers 2, 3 under the control of an in-plane-gate 10. In Figure 3a, it can be seen that the two conducting channels are reduced in width in region 11 near the in-plane-gate. This is achieved either by performing a deep etch or by implanting high energy ions in order to make the implanted regions electrically insulating. An appropriate etch or implantation for this purpose is carried out in regions 12, 13 shown in Figure 3a. Referring to Figure 3b, this shows an example in which a deep etch is utilised so as to define the narrow channel region 11 and the isolation region 12. The complementary conduction channels 2, 3 are shown. Also, the structure of the in-plane-gate 10 can be seen in more detail and includes an ohmic contact 14 with overlying metalisation 16, connected to portions 2a, 3a of both the P and N-type layers 2, 3. Thus, effectively, two in-plane transistors are formed one overlying the other, with a single gate, one transistor having a P-type channel 2 and the other having an N-type channel 3. The provision of the common in-plane-gate arrangement 10 reduces by a factor of 2 the number of gates required to form logic operations.

In use, the voltage applied to the IPG ohmic contact 14 controls the flow of current in the N and P-type channels 2, 3 of region 11 in a complementary fashion. If for example, a positive voltage is applied to the IPG ohmic contact 14, this will enhance the conduction of the negatively charged electrons in the N-type layer 3 of region 11 and reduces the conduction of positively charged holes in the P-type channel of region 11. Conversely, a negative voltage applied to the IPG ohmic contact 14 has the reverse effect, stopping current flow in the N-type channel region 3 and enhancing current flow in the P-type channel 2.

The threshold voltage which has to be applied to the IPG in order to cut off the flow of current is different for each layer 2, 3 and is determined by the doping density within the layer as well as the width of the region 11. Thus, by changing the doping densities, the threshold voltage in each overyling transistor can be tuned to provide the required CIPGL function.

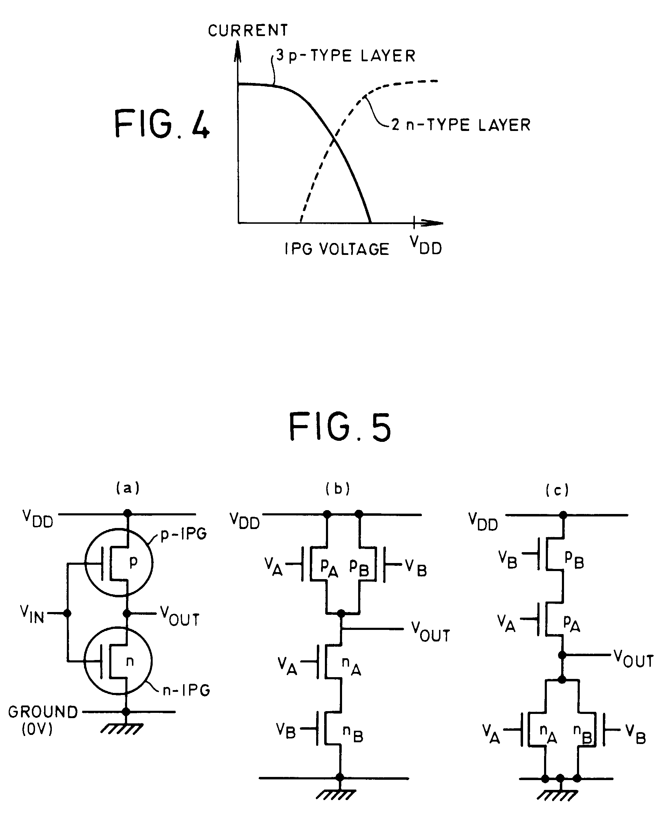

In a specific example, the CIPGL circuits operate with IPG transistors in an enhancement mode for the N-type layer 2 and in a depletion mode for the P-type layer 3. These two modes are illustrated in Figure 4 which shows the current verses voltage characteristics of the two layers 2, 3. It can be seen that for zero IPG voltage, current may flow in the P-type layer 3 but not in the N-type layer 2, and when the IPG voltage is set to Vdd the converse situation occurs. The structural components described hereinbefore can be used as building blocks to achieve Invert, NAND and NOR logic operations. It is well known that these three basic binary functions can be used to perform in different combinations many digital logic operations. The characteristics of Invert, NAND and NOR logic operations are set out in Table 1.

**TABLE 1**

| (a) Invert | | (b) NAND | | | (c) NOR | | |
|---|---|---|---|---|---|---|---|
| IN | OUT | A | B | OUT | A | B | OUT |
| 0 | 1 | 0 | 0 | 1 | 0 | 0 | 1 |
| 1 | 0 | 0 | 1 | 1 | 0 | 1 | 0 |
| | | 1 | 0 | 1 | 1 | 0 | 0 |
| | | 1 | 1 | 0 | 1 | 1 | 0 |

In the CIPGL, high voltages (+ V_{dd}) and low voltages (0) are used to present binary numbers 1 or 0 respectively. Considering Table 1(a), the Invert function takes as its input a binary number and produces an output which is the opposite binary number to the input. The NAND and NOR functions shown in logic Tables 1(b) and 1(c) above each take two binary numbers A and B as their inputs and produce an output according to the logic of Tables 1(b) and 1(c) respectively.

Referring now to Figure 5, Figures 5a, b and c are respectively circuit diagrams for performing Invert, NAND and NOR logic functions according to Tables 1(a), 1(b) and 1(c), where the symbols marked p-IPG and n-IPG represent P-type and N-type IPG transistors as hereinbefore described.

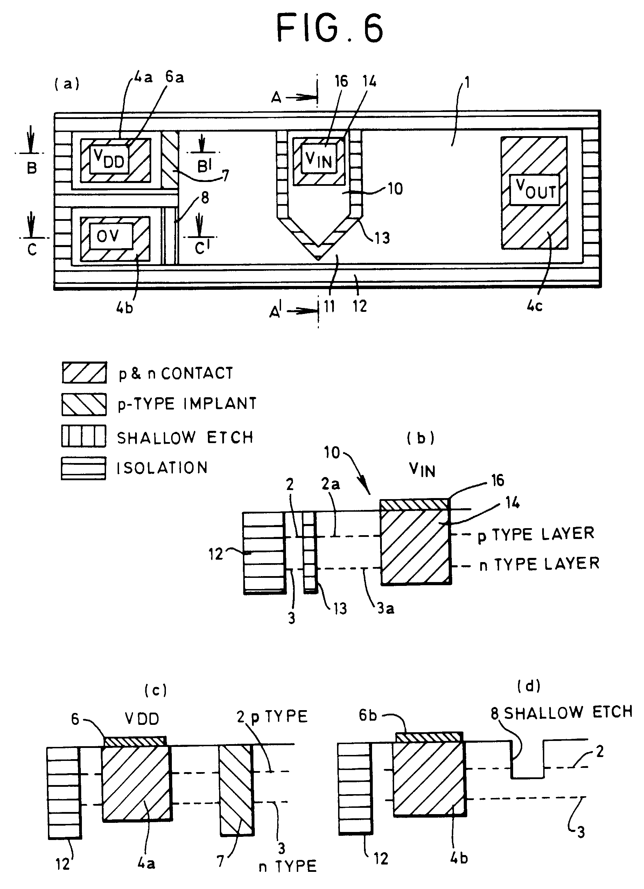

Considering now the Invert circuit in more detail, a practical form thereof will now be described with reference to Figure 6. The device structure is shown in plan view in Figure 6a and the various applied voltages and circuit connections correspond to those shown in the circuit diagram of Figure 5a. Various sections of the device shown in Figure 6a are presented in Figures 6b - d.

The inverter shown in Figure 6 consists of an in-plane-gate arrangement as shown in Figure 3 together with a number of contacts to the P and N-type layers 2, 3 in accordance with the principles described with reference to Figure 2. Thus, referring to Figure 6, the device includes a substrate 1 including the overlying P and N-type layers 2, 3, which includes an in-plane-gate 10 surrounded by an isolation region 13 so as to define a channel region 11 confining channels of the P and N-type layers 2, 3. This can be seen in detail in the section of Figure 6b. Thus, a p-IPG and n-IPG complementary transistor pair is formed with a common in-plane-gate that receives gate voltage V_{IN} at terminal 16. The source-drain paths of the complementary transistors are connected in series between rail voltages V_{DD} and 0V.

The connection of the source-drain path of transistor p-IPG to the rail voltage V_{DD} is shown in detail in Figure 6c. This configuration provides an ohmic contact solely to the P-type layer 2 in the transistor channel, in the manner described with reference to Figure 2b. Thus, the rail voltage V_{DD} is applied to ohmic contact 4 through metallisation 6, which is connected solely to the P-type layer 2 in the channel as a result of the action of P-type implant 7, which inhibits connection of the N-type layer 3 to the ohmic contact.

Similarly, a shown in Figure 6d, the 0V rail voltage is connected to the source-drain path of complementary transistor n-IPG by means of an ohmic contact 4b which is connected solely to the N-type layer 3 in the transistor channel. As described with reference to Figure 2c, the ohmic contact 4b is isolated from the P-type layer 2 by a trench 8 formed by shallow etching. Thus, the 0V rail voltage is applied through metallisation 6b to the ohmic contact.

The output of the inverter is taken from ohmic contact 4c shown in Figure 6a, which contacts both of the layers 2, 3 in accordance with the principles described with reference to Figure 2a.

The inverter can thus operate in accordance with the logic Table 1(a) and has the advantage of taking up little space on the semiconductor substrate due to the overlying arrangement of the complementary transistors.

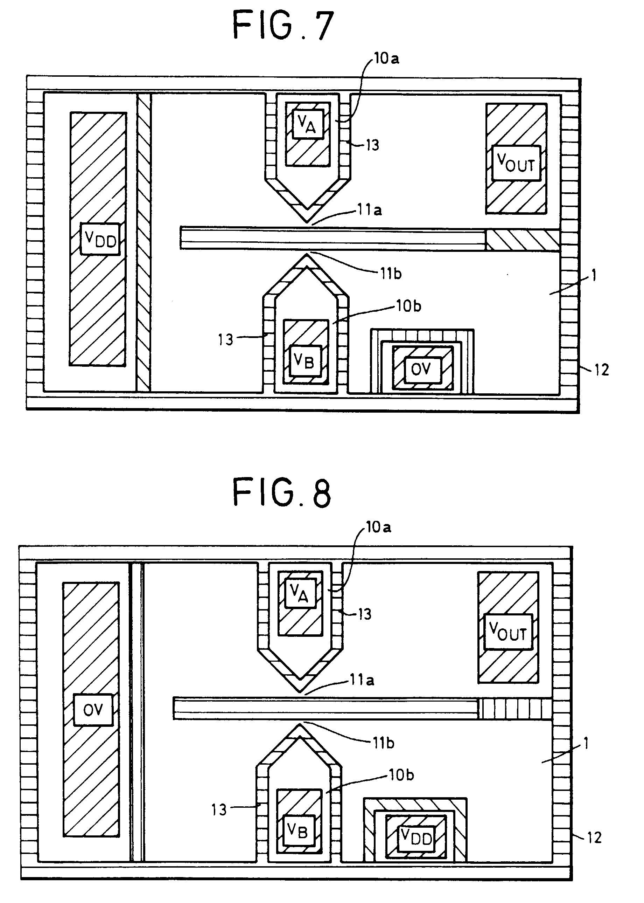

Referring now to Figure 7, this shows a plan view of a NAND circuit, and the key to the various component areas is the same as shown in Figure 6 and the circuit diagram of the device is the same as that shown in Figure 5b. An in-plane-gate 10a controls conduction in channel 11a whereas in-plane-gate 10b controls the conduction in channel 11b. The channel 11a defines the transistors p_{A} and n_{A} shown in Figure 5a, whereas the channel 11b defines the transistors n_{B} and p_{B}. Various dopant and shallow etch regions define the connections for V_{DD}, 0_{V} and V_{OUT} in accordance with the principles described with reference to Figure 2, so as to achieve the circuit configuration shown in Figure 5b. The resulting device operates in accordance with the truth Table 1(b).

Figure 8 shows a plan view of a NOR circuit in the configuration of Figure 5c. Again, two in-plane-gates 10a, 10b are used in the substrate 1 to define channel regions 11a, 11b that provide complementary transistor pairs p_{A} and n_{A}; p_{B}, n_{B}. The peripheral connections differ from those shown in Figure 7, in accordance with the key shown in Figure 6, to achieve the desired circuit configuration.

It will be seen that the geometrical configuration of Figures 7 and 8 are similar and only the peripheral connections need to be altered to produce either NAND or NOR gates. This simplifies manufacture. Again, since the transistors are arranged in overlying pairs, the number of peripheral connections are reduced significantly compared with conventional CMOSFET devices.

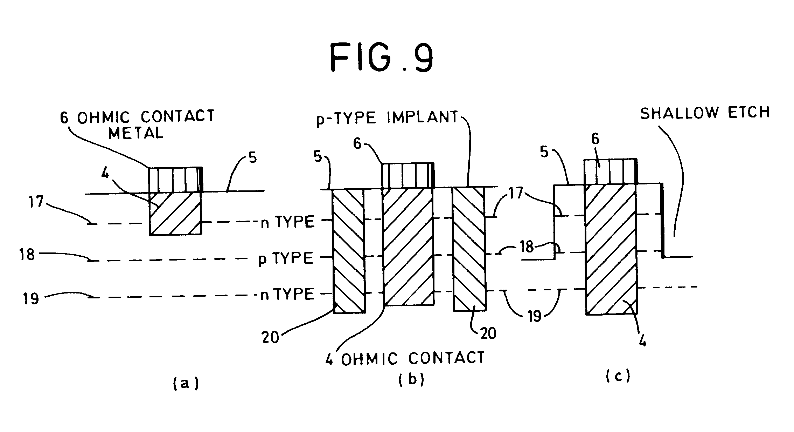

In the examples described hereinbefore, first and second P-type and N-type conductive layers 2, 3 are used. However, the invention is not limited to the use of two complementary layers and a larger plurality of such layers can be formed one overlying the other. An example of how connections can be made to three overlying layers is shown in Figure 9. The semiconductor substrate 1 is provided with an N-type layer 17, a P-type layer 18 and a further N-type layer 19 by delta-doping, the manner described with reference to Figure 1. Contact to the uppermost N-type layer 17 is achieved as shown in Figure 9a, by means of an ohmic contact 4 of the type previously described, implanted into the substrate to a depth which makes contact solely with the uppermost N-type layer 17.

Referring to Figure 9b, the contact to the P-type layer is achieved by means of P-type implants 20, corresponding to the implants 7 of Figure 2b, which extend around an ohmic contact 4 formed to a depth to contact the P-type layer 18. The P-type implants 20, prevent conduction between the N-type layers 17, 19 and the ohmic contact but since the implants 20 are P-type, conduction can occur between the P-type layer 18 and the ohmic contact 4. Thus, the arrangement provides selective connection to layer 18.

Referring to Figure 9c, selective connection to the lowermost N-type layer is achieved by means of a selective shallow etch which physically disconnects layers 17 and 18 from the ohmic contact 4.

It will be appreciated that the invention can be extended to further overlying layers to provide a complex vertical complementary structure. Furthermore, whilst the described embodiments make use of GaAs fabrication technology, it will be appreciated that other technologies could be used, for example Si technology.

## Claims

1. A complementary conductive device comprising: a substrate (1,2,3) including first and second layers (2, 3) of different conductivity type overlying one another to provide first and second complementary conductive channels;
first connecting means (4, 5, 6, 7) providing an electrical connection to the first layer (2) to provide a connection to said first channel;
second connecting means (4, 5, 6, 8) providing an electrical connection to the second layer (3) to provide a connection to the second channel;
and a gate (10, 13, 14, 16) adapted to apply a common gate field to both of the channels (2, 3) concurrently, so as to produce complementary changes in the conductivity thereof, **characterised by** the gate including overlying first and second regions (2a, 3a) of said respective first and second layers, and a conductive gate contact region (14) extending downwardly into the substrate so as to form an electrical connection with both said regions (2a, 3a), and a barrier (13) separating both of said regions (2a, 3a,) from said first and second channels (2, 3).

2. A device according to claim 1 wherein said barrier comprises a trench (13) formed in the substrate between the channels and the gate.

3. A device according to claim 1 wherein the barrier comprises an ion implantation region (13) separating the gate from the channels.

4. A device according to any preceding claim wherein the first layer (2) overlies the second layer (3), the second connecting means (4) extending through the first layer to form a connection with the second layer (3), and including isolating means (8) for electrically isolating the second connecting means from current flow in the first channel (2).

5. A device according to claim 4 wherein the isolating means comprises a trench (8) formed in the substrate to a depth which extends through the first layer but not the second layer.

6. A device according to claim 4 or 5 wherein the first connecting means (4) extends through the first layer to the second layer, and including an isolating region (7) that electrically isolates the first connecting means from the second channel (3).

7. A device according to claim 6 wherein said isolation region includes a region (7) of the same conductivity type as the first layer (2), disposed around the first connecting means where it contacts the second layer (3).

8. A device according to any preceding claim wherein the channels (2, 3) are formed in respective generally parallel planes.

9. A device according to any preceding claim wherein the channels are connected in series.

10. A device according to claim 9 arranged as an inverter.

11. A logic gate arrangement including two devices according to any one of claims 1 to 8 forming first and second complementary pairs of transistors, wherein a first pair of transistors of the same conductivity type are connected in parallel and a second pair of different conductivity type are connected in series.

12. A device according to claim 11 operable as a NAND circuit.

13. A device according to claim 11 operable as a NOR circuit.

14. A device according to any preceding claim wherein said first layer is a P-type layer and the second layer is a N-type layer.

15. A device according to any preceding claim including at least one further conductive layer underlying said first layer, and means providing selective electrical connection to said at least one further conductive layer.

## Patentansprüche

1. Komplementäre leitfähige Vorrichtung, mit einem Substrat (1, 2, 3), das erste und zweite Schichten (2, 3) von verschiedenem Leitfähigkeitstyp enthält, die übereinanderliegen, um erste und zweite komplementäre leitfähige Kanäle zu bilden,
einer ersten Verbindungseinrichtung (4, 5, 6, 7), die eine elektrische Verbindung mit der ersten Schicht (2) bildet, um eine Verbindung mit dem ersten Kanal zu bilden,
einer zweiten Verbindungseinrichtung (4, 5, 6, 8), die eine elektrische Verbindung mit der zweiten Schicht (3) bildet, um eine Verbindung mit dem zweiten Kanal zu bilden,
und einem Gate (10, 13, 14, 16) das dafür eingerichtet ist, ein gemeinsames Gate-Feld an beide Kanäle (2, 3) gleichzeitig anzulegen, um komplementäre Änderungen ihrer Leitfähigkeit zu erzeugen, **dadurch gekennzeichnet, daß** das Gate übereinanderliegende erste und zweite Bereiche (2a, 3a) der ersten bzw. der zweiten Schicht, einen leitfähigen Gate-Kontaktbereich (14), der sich nach unten in das Substrat hinein erstreckt, um eine elektrische Verbindung mit den beiden Bereichen (2a, 3a) zu bilden, und eine Barriere (13) enthält, welche die beiden Bereiche (2a, 3a) von den ersten und zweiten Kanälen (2, 3) trennt.

2. Vorrichtung nach Anspruchl, bei der die Barriere einen Graben (13) aufweist, der zwischen den Kanälen und dem Gate in dem Substrat gebildet ist.

3. Vorrichtung nach Anspruch 1, bei der die Barriere einen lonenimplantationsbereich (13) aufweist, der das Gate von den Kanälen trennt.

4. Vorrichtung nach einem der vorhergehenden Ansprüche, bei der die erste Schicht (2) über der zweiten Schicht (3) liegt und sich die zweite Verbindungseinrichtung (4) durch die erste Schicht hindurch erstreckt, um eine Verbindung mit der zweiten Schicht (3) zu bilden, und mit einer Trenneinrichtung (8), um die zweite Verbindungseinrichtung elektrisch vom Stromfluß im ersten Kanal (2) zu trennen.

5. Vorrichtung nach Anspruch 4, bei der die Trenneinrichtung einen Graben (8) aufweist, der bis in eine Tiefe, die sich durch die erste Schicht, aber nicht die zweite Schicht erstreckt, in dem Substrat gebildet ist.

6. Vorrichtung nach Anspruch 4 oder 5, bei der sich die erste Verbindungseinrichtung (4) durch die erste Schicht hindurch bis zur zweiten Schicht erstreckt, und mit einem Trennbereich (7), der die erste Verbindungseinrichtung elektrisch vom zweiten Kanal (3) trennt.

7. Vorrichtung nach Anspruch 6, bei der der Trennbereich einen Bereich (7) vom gleichen Leitfähigkeitstyp wie die erste Schicht (2) enthält, der um die erste Verbindungseinrichtung herum angeordnet ist, wo er die zweite Schicht (3) berührt.

8. Vorrichtung nach einem der vorhergehenden Ansprüche, bei der die Kanäle (2, 3) in jeweiligen allgemein parallelen Ebenen gebildet sind.

9. Vorrichtung nach einem der vorhergehenden Ansprüche, bei der die Kanäle in Serie verbunden sind.

10. Vorrichtung nach Anspruch 9, angeordnet als ein Inverter.

11. Logikgatteranordnung, die zwei Vorrichtungen nach einem der Ansprüche 1 bis 8 enthält, die erste und zweite komplementäre Transistorpaare bilden, wobei ein erstes Paar Transistoren vom gleichen Leitfähigkeitstyp parallel verbunden sind und ein zweites Paar von verschiedenem Leitfähigkeitstyp in Serie verbunden sind.

12. Vorrichtung nach Anspruch 11, die als eine NAND-Schaltung betriebsfähig ist.

13. Vorrichtung nach Anspruch 11, die als eine NOR-Schaltung betriebsfähig ist.

14. Vorrichtung nach einem der vorhergehenden Ansprüche, bei der die erste Schicht eine P-leitende Schicht ist und die zweite Schicht eine N-leitende Schicht ist.

15. Vorrichtung nach einem der vorhergehenden Ansprüche, die wenigstens eine weitere leitfähige Schicht, die unter der ersten Schicht liegt, und eine Einrichtung enthält, die eine selektive elektrische Verbindung mit der wenigstens einen leitfähigen Schicht bildet.

## Revendications

1. Dispositif conducteur complémentaire comprenant : un substrat (1, 2, 3) comprenant des première et seconde couches (2, 3) d'un type de conductivité différent se recouvrant l'une l'autre afin de procurer des premier et second canaux conducteurs complémentaires,
un premier moyen de connexion (4, 5, 6, 7) procurant une connexion électrique vers la première couche (2) afin d'établir une connexion vers ledit premier canal,
un second moyen de connexion (4, 5, 6, 8) procurant une connexion électrique vers la seconde couche (3) afin d'établir une connexion vers ledit second canal,
et une grille (10, 13, 14, 16) conçue pour appliquer un champ de grille commun aux deux canaux (2, 3), simultanément, de façon à produire des variations complémentaires de la conductivité de ceux-ci, **caractérisé par** la grille comprenant des première et seconde régions superposées (2a, 3a) desdites première et seconde couches respectives, et une région de contact de grille conducteur (14) s'étendant vers le bas jusque dans le substrat de façon à former une connexion électrique avec les deux dites régions (2a, 3a) et une barrière (13) séparant les deux dites régions (2a, 3a) desdits premier et second canaux (2, 3).

2. Dispositif selon la revendication 1, dans lequel ladite barrière comprend une tranchée (13) formée dans le substrat entre les canaux et la grille.

3. Dispositif selon la revendication 1, dans lequel la barrière comprend une région d'implantation d'ions (13) séparant la grille des canaux.

4. Dispositif selon l'une quelconque des revendications précédentes, dans lequel la première couche (2) recouvre la seconde couche (3), le second moyen de connexion (4) s'étendant au travers de la première couche afin de former une connexion avec la seconde couche (3), et comprenant un moyen d'isolement (8) afin d'isoler électriquement le second moyen de connexion de la circulation du courant dans le premier canal (2).

5. Dispositif selon la revendication 4, dans lequel le moyen d'isolement comprend une tranchée (8) formée dans le substrat jusqu'à une profondeur qui s'étend au travers de la première couche mais non pas de la seconde couche.

6. Dispositif selon la revendication 4 ou 5, dans lequel le premier moyen de connexion (4) s'étend au travers de la première couche jusqu'à la seconde couche, et comprenant une région d'isolement (7) qui isole électriquement le premier moyen de connexion du second canal (3).

7. Dispositif selon la revendication 6, dans lequel ladite région d'isolement comprend une région (7) du même type de conductivité que la première couche (2), disposée autour du premier moyen de connexion où il entre en contact avec la seconde couche (3).

8. Dispositif selon l'une quelconque des revendications précédentes, dans lequel les canaux (2, 3) sont formés dans des plans respectifs généralement parallèles.

9. Dispositif selon l'une quelconque des revendications précédentes, dans lequel les canaux sont reliés en série.

10. Dispositif selon la revendication 9, agencé sous forme d'un inverseur.

11. Agencement de porte logique comprenant deux dispositifs selon l'une quelconque des revendications 1 à 8, formant des première et seconde paires complémentaires de transistors, dans lequel une première paire de transistors de même type de conductivité sont reliés en parallèle et une seconde paire de type de conductivité différents sont reliés en série.

12. Dispositif selon la revendication 11, pouvant être mis en oeuvre sous forme d'un circuit NON ET.

13. Dispositif selon la revendication 11, pouvant être mis en oeuvre sous forme d'un circuit NON OU.

14. Dispositif selon l'une quelconque des revendications précédentes, dans lequel ladite première couche est une couche de type P et la seconde couche est une couche de type N.

15. Dispositif selon l'une quelconque des revendications précédentes, comprenant au moins une autre couche conductrice disposée sous ladite première couche, et un moyen procurant une connexion électrique sélective à ladite au moins une autre couche conductrice.
